# EUROPEAN PATENT APPLICATION

(11) **EP 4 414 122 A1**
(43) Date of publication of application: **14.08.2024**
(21) Application number: 23155396.7
(22) Date of filing: 07.02.2023
(51) Int. Cl.: B23K 35/02, H01L 23/00, B23K 1/00

(54) **SOLDERABLE ELECTRONIC DEVICE AND METHOD FOR FABRICATING THE SAME**

(71) Applicant: Infineon Technologies AG, 85579 Neubiberg (DE)
(72) Inventor: ROTH, Alexander, 93197 Zeitlarn (DE); WATERLOO, Andreas, 93049 Regensburg (DE)
(74) Representative: Lambsdorff & Lange Patentanwälte Partnerschaft mbB

(57) **Abstract**

A solderable electronic device comprises a base comprising one or more of a semiconductor die and a power electronic substrate, a first layer arranged over the base, the first layer comprising a solid reducing agent, and a solder preform arranged over the first layer, wherein the reducing agent is configured to reduce a solder material of the solder preform during a soldering process.

## Description

### TECHNICAL FIELD

This disclosure relates in general to a solderable electronic device as well as to a method for fabricating a solderable electronic device.

### BACKGROUND

Fabricating a semiconductor device, e.g. a power semiconductor package or a power semiconductor module, may comprise soldering a semiconductor die onto a substrate. Preparing the soldering process may comprise providing a solderable electronic device comprising a stack with the substrate, the semiconductor die and a solder preform comprising solder material arranged between the semiconductor die and the substrate. In order to ensure that a proper solder joint is formed, it may be necessary to remove any contaminating oxide layer from the surfaces involved in the soldering process, e.g. the surface of the solder preform, the surface of the substrate and/or the surface of the die. The oxide layer may for example be removed using an atmosphere comprising formic acid to trigger a reduction reaction. However, for example in the case that a particularly thin solder preform is used, the formic acid vapor may not be able to sufficiently permeate the solder material and activate the involved surfaces. Improved solderable electronic devices and improved methods for fabricating solderable electronic devices may help with solving these and other problems.

The problem on which the invention is based is solved by the features of the independent claims. Further advantageous examples are described in the dependent claims.

### SUMMARY

Various aspects pertain to a solderable electronic device, comprising: a base comprising one or more of a semiconductor die and a power electronic substrate, a first layer arranged over the base, the first layer comprising a solid reducing agent, and a solder preform arranged over the first layer, wherein the reducing agent is configured to reduce a solder material of the solder preform during a soldering process.

Various aspects pertain to a method for fabricating a solderable electronic device, the method comprising: providing a base comprising one or more of a semiconductor die and a leadframe, arranging a first layer over the base, the first layer comprising a solid reducing agent, and arranging a solder preform over the first layer, wherein the reducing agent is configured to reduce a solder material of the solder preform during a soldering process.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figure 1 shows a sectional view of a solderable electronic device, wherein a first layer comprising a reducing agent is arranged between a base and a solder preform.
Figure 2 shows a sectional view of a further solderable electronic device, wherein at least one tacking agent deposit is arranged between the base and the solder preform.
Figure 3 shows a sectional view of a further solderable electronic device, wherein a second layer comprising the reducing agent is arranged over the solder preform.
Figure 4 shows a sectional view of a further solderable electronic device, wherein the first layer only partially covers the solder preform on a first side and wherein the second layer comprises several parts separated from one another.
Figure 5 shows a sectional view of an electronic device which may be obtained by soldering a solderable electronic device as described herein onto a substrate or onto a semiconductor die.
Figure 6 is a flow chart of an exemplary method for fabricating a solderable electronic device.

### DETAILED DESCRIPTION

In the following detailed description, directional terminology, such as "top", "bottom", "left", "right", "upper", "lower" etc., may be used with reference to the orientation of the Figure(s) being described. Because components of the disclosure can be positioned in a number of different orientations, the directional terminology is used for purposes of illustration only. It is to be understood that other examples may be utilized and structural or logical changes may be made.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted. Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "attached", or "connected" elements. However, it is also possible that the "bonded", "attached", or "connected" elements are in direct contact with each other. Also, the term "exemplary" is merely meant as an example, rather than the best or optimal.

The examples of a solderable electronic device described below may use various types of semiconductor dies, among them power MOSFET transistors, power Schottky diodes, JFETs (Junction Gate Field Effect Transistors), power bipolar transistors, MEMS (Micro-Electro-Mechanical-Systems), power integrated circuits, etc. The examples may also use semiconductor dies comprising MOS transistor structures or vertical transistor structures like, for example, IGBT (Insulated Gate Bipolar Transistor) structures or, in general, transistor structures in which at least one electrical contact pad is arranged on a first main face of the semiconductor die and at least one other electrical contact pad is arranged on a second main face of the semiconductor die, opposite to the first main face.

In several examples layers or layer stacks are applied to one another or materials are applied or deposited onto other components. It should be appreciated that any such terms as "applied" or "deposited" are meant to cover literally all kinds and techniques of applying layers onto each other. In particular, they are meant to cover techniques in which layers are applied at once as a whole, as well as techniques in which layers are deposited in a sequential manner.

An efficient solderable electronic device as well as an efficient method for fabricating a solderable electronic device may for example reduce material consumption, ohmic losses, chemical waste, etc. and may thus enable energy and/or resource savings. Improved solderable electronic devices as well as improved methods for fabricating a solderable electronic device, as specified in this description, may thus at least indirectly contribute to green technology solutions, i.e. climate-friendly solutions providing a mitigation of energy and/or resource use.

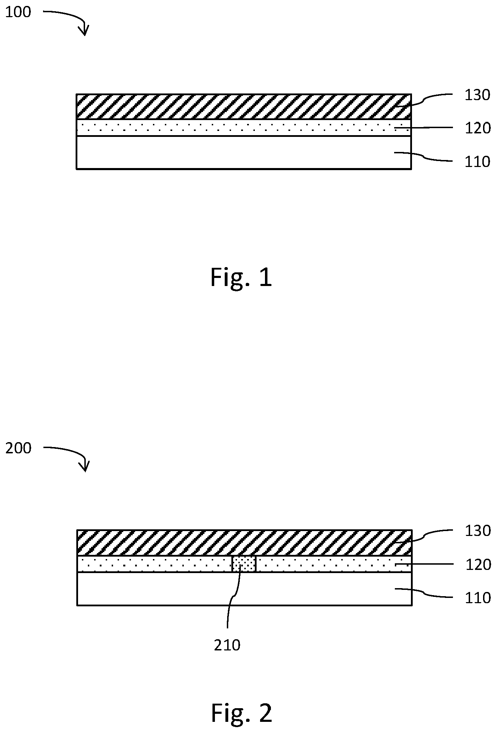

Figure 1 shows a sectional view of a solderable electronic device 100 comprising a base 110, a first layer 120 and a solder preform 130.

According to an example, the solderable electronic device 100 may be an intermediate product of a semiconductor package or a semiconductor module. The solderable electronic device 100 may e.g. be configured to be soldered to a carrier (e.g. a leadframe, a direct copper bond (DCB), a direct aluminum bond (DAB), an active metal braze (AMB), or an insulated metal substrate (IMS). Alternatively or additionally, the solderable electronic device 100 may be configured to be soldered to a semiconductor die.

In the case that the solderable electronic device 100 is an intermediate product of a semiconductor package or module, the end product may be a power electronic device configured to operate with a high voltage and/or a high current. The semiconductor package or module may comprise any suitable electrical circuit, e.g. a converter circuit, an inverter circuit, a half bridge circuit, etc.

The base 110 comprises one or more of a semiconductor die and a power electronic substrate. The base 110 may e.g. comprise or consist of a semiconductor die but no power electronic substrate or the base 110 may comprise or consist of a power electronic substrate but no semiconductor die. A power electronic substrate may e.g. comprise or consist of a leadframe, a DCB, a DAB, an AMB, or an IMS.

The base 110 may have any suitable dimensions for a part of a semiconductor package or a semiconductor module. For example, the base 110 may have a length and a width (measured parallel to the side which faces the first layer 120) of 3mm or more, or 5mm or more, or 10mm or more, or 2cm or more, or 5cm or more, or 10cm or more. The base 110 may for example have a thickness (measured perpendicular to the length and width) of 50pm or more, or 100pm or more, or 150pm or more, or 300pm or more, or 600pm or more, or 1mm or more, or 2mm or more, or 3mm or more.

The base 110 may comprise or consist of any suitable material or material composition. In the case that the base 110 comprises or consists of a semiconductor die, the base 110 may e.g. comprise or consist of Si, SiC, SiGe, GaAs, GaN, etc. In the case that the base 110 comprises or consists of a power electronic substrate, the base 110 may e.g. comprise or consist of Ag, Al, Au, Cu, Ni, or Fe.

In the case that the base 110 comprises or consists of a semiconductor die, the semiconductor die may e.g. be a power semiconductor die, e.g. a MOSFET, an IGBT, or a diode. In the case that the base 110 comprises or consists of a power electronic substrate, the power electronic substrate may be configured as a die carrier for carrying one or more semiconductor dies.

The first layer 120 is arranged over the base 110. The first layer 120 may in particular be arranged over a first side of the base 110. The base 110 may comprise a second side opposite the first side and lateral sides connecting the first and second sides. According to an example, the second side of the base 110 is free of the first layer 120. According to an example, the lateral sides of the base 110 are free of the first layer 120. However, it is also possible that the first layer 120 at least partially covers the lateral sides and/or the second side of the base 110.

The first layer 120 may partially cover the first side of the base 110. For example, 30% or more, or 50% or more, or 70% or more, or 90% or more of the first side of the base 110 may be covered by the first layer 120. For example, the first layer 120 may cover an interior part of the first side of the base 110 and not a periphery of the first side, surrounding the interior part. It is also possible that the first layer 120 covers the whole or essentially the whole of the first side of the base 110.

The first layer 120 may have any suitable thickness, e.g. a thickness in the range of about 0.1µm to about 20pm. The lower limit of this range may also be about 0.2pm, or 0.3pm, or 0.5pm, or 1pm, or 2um. The upper limit of this range may also be about 15pm, or about 10µm, or about 5µm.

The solder preform 130 is arranged over the first layer 120. The solder preform 130 may comprise a solder material configured to form a solder joint between the base 110 and a further component. The further component may e.g. comprise or consist of a power electronic substrate or a semiconductor die.

According to an example, the solder preform 130 is deposited over the base 110 and the first layer 120 as a whole. In other words, the solder preform 130 may essentially be a solid body. According to another example, the solder preform 130 is deposited in the form of a paste.

The solder preform 130 may comprise any suitable solder material, for example a solder material comprising or consisting of Sn and/or Ag. The solder material may e.g. be a soft solder material or a diffusion solder material. The solder material may be a lead-free solder material or a lead-based solder material. The solder preform 130 may solely consist of solder material or the solder preform 130 may comprise additional components, e.g. components which are evaporated before or during soldering.

The preform 130 may essentially have a similar or identical length and width as the first layer 120. The preform 130 may have any suitable thickness, for example a thickness of 2µm or more, or 10µm or more, or 50pm or more, or 100pm or more, or 150pm or more.

The first layer 120 comprises a solid reducing agent, wherein the reducing agent is configured to chemically reduce the solder material of the solder preform during a soldering process. The reducing agent may be "solid" in the sense that it is not in gaseous or liquid form.

By providing the reducing agent locally in the first layer 120, it may not be necessary to provide a reducing atmosphere (e.g. an atmosphere comprising formic acid) prior or during the soldering process. In other words, the reducing agent is not provided globally but locally. This may for example simplify the soldering process, saving costs and/or prevent the reducing agent from corroding other components of the solderable electronic device 100. Furthermore, by providing the reducing agent in the first layer 120 between the solder preform 130 and the base 110, it may be ensured that all surfaces involved in the soldering process are properly freed of an oxide layer.

The reducing agent may be configured to reduce the solder material at elevated temperatures, for example at temperatures of about 200°C or more. The reducing agent may in particular be configured to reduce the solder material at temperatures prevailing during the soldering process. Furthermore, the reducing agent may be configured to decompose after the reducing reaction, for example into small molecules like water, CO₂, etc. As a result of the soldering process, the first layer 120 may be completely consumed.

The reducing agent may for example comprise or consist of an organic peroxide and/or an inorganic peroxide. The reducing agent may for example comprise or consist of an inorganic acid and/or a salt of an organic acid. The reducing agent may for example comprise or consist of an ester of an organic acid. Furthermore, the reducing agent may for example comprise or consist of carbonyl complexes, e.g. metal carbonyls.

Exemplary organic peroxides which may be used for the reducing agent are: diisobutyryl peroxide, cumene peroxyneodecanoate, 1,1,3,3-tetramethylbutyl peroxyneodecanoate, di-n-propyl peroxydicarbonate, tert-amyl-peroxyneodecanoate, di-(2-ethylhexyl)-peroxydicarbonate, tert-butyl peroxyneodecanoate, di-n-butyl peroxydicarbonate, 1,1,3,3-tetramethylbutyl peroxypivalate, tert-butyl peroxyneoheptanoate, tert-amyl peroxypivalate, tert-butyl peroxypivalate, di-(3,5,5-trimethylhexanoyl) peroxide, tert-butyl peroxy-2-ethylhexanoate, tert-butyl peroxyisobutyrate, 1,1-di-(tert-butylperoxy)-3,3,5-trimethylcyclohexane, 1,1-di-(tert-butylperoxy)-cyclohexane, tert-butyl-peroxy-3,5,5-trimethylhexanoate, 2,2-di-(tert-butylperoxy)-butane, tert-butylperoxyisopropylcarbonate, tert-butyl peroxyacetate, 2,5-dimethyl-2,5-di(2-ethylhexanoylperoxy)-hexane, 1,1,3,3-tetramethylbutyl-peroxy-2-ethylhexanoate, tert-amyl-peroxy-2-ethylhexanoate, tert-butyl peroxydiethylacetate, tert-amylperoxy-2-ethylhexylcarbonate, tert-butyl-peroxy-2-ethylhexylcarbonate,tert-butyl peroxybenzoate, di-tert amylperoxide, 2,5-dimethyl-2,5-di-(tert-butylperoxy)-hexane, tert-butylcumyl peroxide, 2,5-dimethyl-2,5-di(tert-butylperoxy)hexyne-3, di-tert-butyl peroxide, 3,6,9-triethyl-3,6,9-trimethyl-1,4,7-triperoxonane, di-isopropylbenzene monohydroperoxide, p-menthane hydroperoxide, cumene hydroperoxide, dicumyl peroxide, and 1,1,3,3- tetramethylbutyl hydroperoxide.

Exemplary inorganic peroxides which may be used for the reducing agent are: hydrogen peroxide, ammonium peroxide, lithium peroxide, sodium peroxide, potassium peroxide, magnesium peroxide, calcium peroxide, barium peroxide, and peroxoborates.

An exemplary inorganic acid which may be used for the reducing agent is a phosphoric acid.

Exemplary salts of organic acids which may be used for the reducing agent are salts of organic acids, wherein the organic acids have 1-4 carbon atoms, consisting of acetates, carbonates, formates, lactates, oxalates, and maleates. Such salts may be magnesium formate, aluminum formate, iron(II) formate, tin(II) formate, copper(II) formate, silver(II) formate, and manganese(III) formate, copper(II) lactate and silver(I) lactate. Furthermore, derivatives of formats may also be used, such as methyl formate, ethyl formate, propyl formate, and butyl formate. The salt or the salts may for example be dissolved in any volumetric ratio of polyethylene glycol, terpineols, amino-2-propanol, or hexylamine.

According to an example, the first layer 120 may optionally comprise a plasticizing agent and/or a filler. The plasticizing agent and/or the filler may for example comprise one or more of a fatty acid, a fatty acid salt, a fatty acid ester, an acrylic polymer and a terpineol. It is also possible that any suitable combination of these ingredients may be used.

The first layer 120 may comprise any suitable amount of the reducing agent. For example, the reducing agent may account for 10vol% or more, or 20vol% or more, or 30vol% or more, or 40vol% or more, or 50vol% or more, or 60vol% or more, or 70vol% or more, or 80vol% or more, or 90vol% or more of the first layer 120. The remainder may for example consist of the plasticizing agent and/or the filler (except for unavoidable contaminants). The first layer 120 may also solely consist of the reducing agent (except for unavoidable contaminants) .
Examples of such a layer may incorporate 35% of reducing agent (e.g. formates), 50% terpineol and 15% pentadecylic acid; resulting in a mixture that is solid at less than 30°C, and is mostly liquid at temperatures between 30°C and 200°C; evaporates its fillers > 260°C and reduces contact partners at commonly used soldering temperatures by way of the well-known formate-metal oxide interaction.

Different methods of depositing the first layer 120 onto the base 110 may be used. For example, depositing the first layer 120 may comprise mixing the target composition with a volatile solvent, spraying the solution onto the surface of the base 110 and evaporating the solvent under temperature and/or low pressure/vacuum.

According to another example, depositing the first layer 120 may comprise producing a sheet comprising the reducing agent and applying this sheet to the die or substrate or solder preform under mechanical pressure.

According to another example, depositing the first layer 120 may comprise in situ reacting a backside metallization of the semiconductor die or a metal surface of the power electronic substrate or the solder material of the solder preform 130 with the requisite acid to form the salts or esters of the solid reducing layer.

Figure 2 shows a sectional view of a further solderable electronic device 200 which may be similar or identical to the solderable electronic device 100, except for the differences described in the following.

In the solderable electronic device 200, the first layer 120 additionally comprises a tacking agent configured to at least temporarily tack the base 110 and the solder preform 130 onto each other. This may e.g. prevent the base 110 and the solder preform 130 from shifting out of place relative to each other before the solder joint has been formed. The tacking agent may for example comprise or consist of a suitable mixture of an acrylic polymer and a terpineol.

The first layer 120 may comprise any suitable amount of the tacking agent. For example, 2% or more, or 5% or more, or 10% or more of the first layer 120 may comprise or consist of the tacking agent.

According to an example, the tacking agent is provided in the form of one or more deposits 210 arranged between the base 110 and the solder preform 130 (compare Fig. 2). The tacking agent deposit(s) 210 may be separate from the rest of the first layer 120 and may be deposited in a separate process as the rest of the first layer 120. In other words, the tacking agent deposit(s) 210 comprise or consist of the tacking agent but do not necessarily comprise the components of the first layer 120 described above (except for unavoidable contaminants).

According to an example, the tacking agent deposit(s) 210 are deposited on the base 110 or on the solder preform 130 prior to depositing the rest of the first layer 120. In other words, the rest of the first layer 120 is deposited around the tacking agent deposit(s) 210. According to another example, the tacking agent deposit(s) 210 are deposited after the rest of the first layer 120 has been deposited.

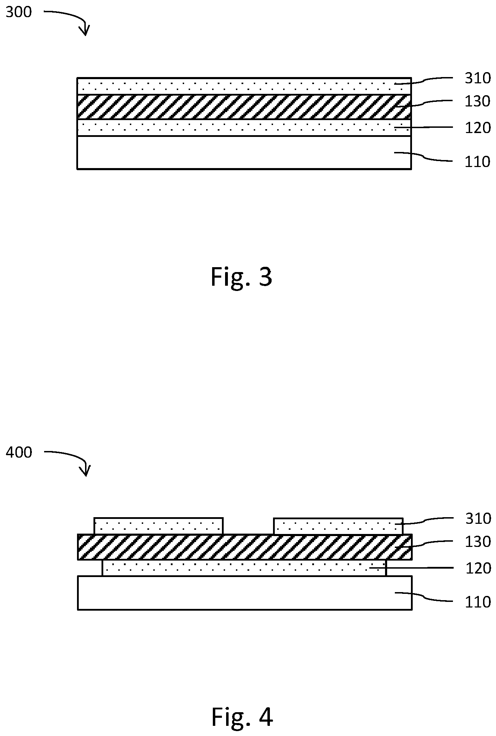

Figure 3 shows a sectional view of a further solderable electronic device 300 which may be similar or identical to the solderable electronic device 100 or 200, except for the differences described in the following.

In particular, the solderable electronic device 300 comprises a second layer 310 arranged over the solder preform 130. In other words, the solder preform 130 may be at least partially covered by the first layer 120 on a first side and it may be at least partially covered by the second layer 310 on an opposite second side.

The second layer 310 comprises the solid reducing agent described further above. According to an example, the first and second layers 120, 310 may essentially have the same dimensions and/or essentially the same composition. According to another example, the first and second layers 120, 310 may have differing dimensions and/or differing compositions.

Providing the reducing agent on both sides of the preform 130 as shown in Fig. 3 may e.g. ensure that the solder material is thoroughly reduced on both sides. This may in turn improve the results of the soldering process.

Figure 4 shows a sectional view of a further solderable electronic device 400 which may be similar or identical to the solderable electronic device 100, 200, or 300, except for the differences described in the following.

As shown in Fig. 4, the first layer 120 only partially covers the first side of the solder preform 130. According to an example, the first layer 120 alternatively or additionally only partially covers the first side of the base 110 (this example is shown in Fig. 4). Alternatively or additionally, it is also possible that the second layer 310 only partially covers the second side of the solder preform 130.

In order to ensure that the solder material of the solder preform 130 can be reduced by the reducing agent to a sufficient degree, it may be necessary that the first layer 120 and/or the second layer 310 cover 40% or more, or 50% or more, or 60% or more of the first side, respectively the second side of the solder preform 130.

As shown with respect to the first layer 120, a single contiguous layer may be used to at least partially cover a side of the solder preform 130. However, as shown with respect to the second layer 310, it is also possible that several separate layer parts are used to at least partially cover a side of the solder preform 130 (as long as the side is covered to a sufficient degree, as described above).

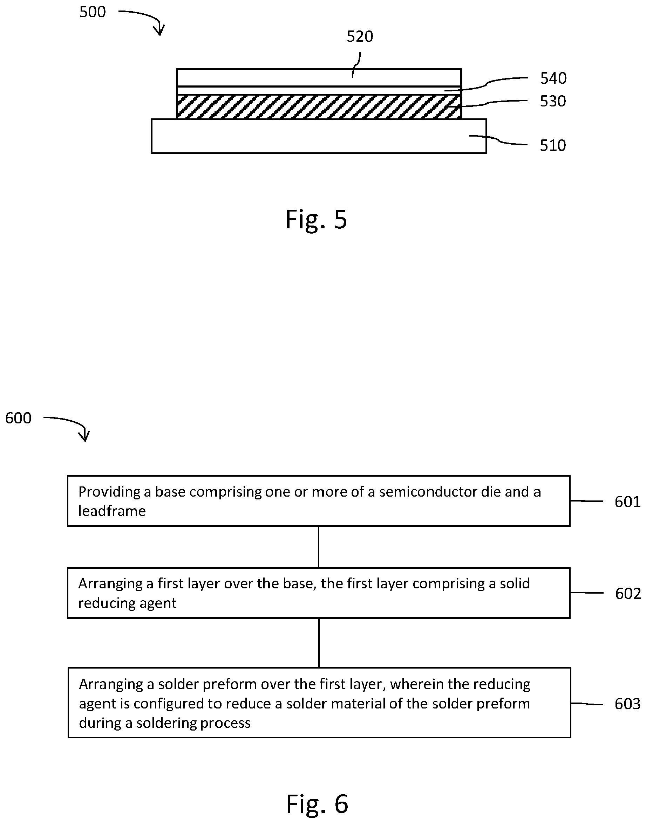

Figure 5 shows an electronic device 500 comprising a power electronic substrate 510, a semiconductor die 520 and a solder joint 530 coupling the semiconductor die 520 to the substrate 510. The electronic device 500 may be fabricated by soldering the solderable electronic device 100, 200, 300, or 400 to the power electronic substrate 510 (in the case that the base 110 comprises the semiconductor die 520) or by soldering the solderable electronic device 100, 200, 300, or 400 to the semiconductor die 520 (in the case that the base 110 comprises the electronic substrate 510).

According to an example, the electronic device 500, in particular the semiconductor die 520, may comprise a backside metallization 540. The backside metallization 540 may for example comprise or consist of Cu, Ni, Ti or any other suitable material. The solder joint 530 may be arranged between the backside metallization 540 and the power electronic substrate 510. The solder joint 530 may e.g. from a diffusion solder bond to the backside metallization 540 and/or to the power electronic substrate 510. The solder joint 530 may also e.g. form a soft solder bond.

Figure 6 is a flow chart of a method 600 for fabricating a solderable electronic device. The method 600 may e.g. be used to fabricate the solderable electronic devices 100 to 400.

The method 600 comprises at 601 a process of providing a base comprising one or more of a semiconductor die and a leadframe, at 602 a process of arranging a first layer over the base, the first layer comprising a solid reducing agent, and at 603 a process of arranging a solder preform over the first layer, wherein the reducing agent is configured to reduce a solder material of the solder preform during a soldering process.

According to an example of the method 600, the process 602 of arranging the first layer over the base comprises spraying a solution onto the base, the solution comprising the constituents of the first layer dissolved in a solvent, and evaporating the solvent. According to another example of the method 600, the process 602 of arranging the first layer over the base comprises providing the first layer in solid form, and applying the first layer to the base and/or to the solder preform under mechanical pressure.

### EXAMPLES

In the following, the solderable electronic device as well as the method for fabricating a solderable electronic device are further explained using specific examples.

Example 1 is a solderable electronic device, comprising: a base comprising one or more of a semiconductor die and a power electronic substrate, a first layer arranged over the base, the first layer comprising a solid reducing agent, and a solder preform arranged over the first layer, wherein the reducing agent is configured to reduce a solder material of the solder preform during a soldering process.

Example 2 is the solderable electronic device of example 1, wherein the solder material is configured to form an intermetallic phase with the base.

Example 3 is the solderable electronic device of example 1 or 2, wherein the reducing agent comprises an organic peroxide and/or an inorganic peroxide.

Example 4 is the solderable electronic device of one of the preceding examples, wherein the reducing agent comprises an inorganic acid and/or a salt of an organic acid.

Example 5 is the solderable electronic device of one of the preceding examples, wherein the reducing agent comprises an ester of an organic acid.

Example 6 is the solderable electronic device of one of the preceding examples, wherein the reducing agent comprises carbonyl complexes.

Example 7 is the solderable electronic device of one of the preceding examples, wherein the first layer further comprises a plasticizing agent and/or a filler.

Example 8 is the solderable electronic device of example 7, wherein the plasticizing agent and/or the filler comprises one or more of a fatty acid, a fatty acid salt, a fatty acid ester, an acrylic polymer and a terpineol.

Example 9 is the solderable electronic device of one of the preceding examples, wherein the first layer further comprises a tacking agent, the tacking agent comprising a mixture of an acrylic polymer and a terpineol.

Example 10 is the solderable electronic device of one of the preceding examples, wherein a thickness of the first layer is in the range of 0.1µm and 20µm.

Example 11 is the solderable electronic device of one of the preceding examples, further comprising: a second layer arranged over the solder preform, the second layer comprising the solid reducing agent.

Example 12 is a method for fabricating a solderable electronic device, the method comprising: providing a base comprising one or more of a semiconductor die and a leadframe, arranging a first layer over the base, the first layer comprising a solid reducing agent, and arranging a solder preform over the first layer, wherein the reducing agent is configured to reduce a solder material of the solder preform during a soldering process.

Example 13 is the method of example 12, wherein arranging the first layer over the base comprises: spraying a solution onto the base, the solution comprising the constituents of the first layer dissolved in a solvent, and evaporating the solvent.

Example 14 is the method of example 12, wherein arranging the first layer over the base comprises: providing the first layer in solid form, and applying the first layer to the base and/or to the solder preform under mechanical pressure.

Example 15 is the method of one of examples 12 to 14, wherein arranging the first layer over the base comprises: providing a tacking agent, the tacking agent comprising a mixture of an acrylic polymer and a terpineol.

Example 16 is an apparatus comprising means for performing the method according to anyone of examples 12 to 15.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. A solderable electronic device (100), comprising:
a base (110) comprising one or more of a semiconductor die and a power electronic substrate,
a first layer (120) arranged over the base (110), the first layer (120) comprising a solid reducing agent, and
a solder preform (130) arranged over the first layer (120),
wherein the reducing agent is configured to reduce a solder material of the solder preform (130) during a soldering process.

2. The solderable electronic device (100) of claim 1, wherein the solder material is configured to form an intermetallic phase with the base (110).

3. The solderable electronic device (100) of claim 1 or 2, wherein the reducing agent comprises an organic peroxide and/or an inorganic peroxide.

4. The solderable electronic device (100) of one of the preceding claims, wherein the reducing agent comprises an inorganic acid and/or a salt of an organic acid.

5. The solderable electronic device (100) of one of the preceding claims, wherein the reducing agent comprises an ester of an organic acid.

6. The solderable electronic device (100) of one of the preceding claims, wherein the reducing agent comprises carbonyl complexes.

7. The solderable electronic device (100) of one of the preceding claims, wherein the first layer (120) further comprises a plasticizing agent and/or a filler.

8. The solderable electronic device (100) of claim 7, wherein the plasticizing agent and/or the filler comprises one or more of a fatty acid, a fatty acid salt, a fatty acid ester, an acrylic polymer and a terpineol.

9. The solderable electronic device (200) of one of the preceding claims, wherein the first layer (120) further comprises a tacking agent (210), the tacking agent (210) comprising a mixture of an acrylic polymer and a terpineol.

10. The solderable electronic device (100) of one of the preceding claims, wherein a thickness of the first layer is in the range of 0.1µm and 20um.

11. The solderable electronic device (300) of one of the preceding claims, further comprising:
a second layer (310) arranged over the solder preform (130), the second layer (310) comprising the solid reducing agent.

12. A method (600) for fabricating a solderable electronic device, the method (600) comprising:
providing (601) a base comprising one or more of a semiconductor die and a leadframe,
arranging (602) a first layer over the base, the first layer comprising a solid reducing agent, and
arranging (603) a solder preform over the first layer,
wherein the reducing agent is configured to reduce a solder material of the solder preform during a soldering process.

13. The method (600) of claim 12, wherein arranging (602) the first layer over the base comprises:
spraying a solution onto the base, the solution comprising the constituents of the first layer dissolved in a solvent, and
evaporating the solvent.

14. The method (600) of claim 12, wherein arranging (602) the first layer over the base comprises:
providing the first layer in solid form, and
applying the first layer to the base and/or to the solder preform under mechanical pressure.

15. The method (600) of one of claims 12 to 14, wherein arranging (602) the first layer over the base comprises:
providing a tacking agent, the tacking agent comprising a mixture of an acrylic polymer and a terpineol.
